Europäisches Patentamt

European Patent Office

Office européen des brevets

(19)

(11) Publication number: **0 167 665**
**B1**

(12)

# EUROPEAN PATENT SPECIFICATION

(45) Date of publication of patent specification: **29.06.88**

(51) Int. Cl.⁴: **H 01 L 23/42, H 05 K 7/20**

(21) Application number: **84114163.3**

(22) Date of filing: **23.11.84**

(54) **Apparatus for cooling integrated circuit chips.**

(30) Priority: **26.12.83 JP 243958/83**

(43) Date of publication of application:
**15.01.86 Bulletin 86/03**

(45) Publication of the grant of the patent:
**29.06.88 Bulletin 88/26**

(84) Designated Contracting States:
**DE GB**

(56) References cited:
**EP-A-0 007 015**

**IBM TECHNICAL DISCLOSURE BULLETIN, vol. 10, no. 10, March 1968, pages 1559-1960, New York, US; R.C.CHU et al.: "Thermal card and deflector system for augmenting emersion cooling"**

(73) Proprietor: **HITACHI, LTD.**
**6, Kanda Surugadai 4-chome Chiyoda-ku Tokyo 100 (JP)**

(72) Inventor: **Nakayama, Wataru**
**2068-41, Masuo Kashiwa-shi**
**Chiba-ken (JP)**
Inventor: **Hirasawa, Shigeki**
**2625-3, Shimoinayoshi Chiyoda-mura**
**Niihari-gun Ibaraki-ken (JP)**
Inventor: **Nakajima, Tadakatsu**
**3602, Shimoinayoshi Chiyoda-mura**
**Niihari-gun Ibaraki-ken (JP)**

(74) Representative: **Finck, Dieter et al**
**Patentanwälte v. Füner, Ebbinghaus, Finck**
**Mariahilfplatz 2 & 3**
**D-8000 München 90 (DE)**

Courier Press, Leamington Spa, England.

## Description

The present invention relates to a cooling apparatus as described in the pre-characterizing portion of claim 1, which is known from EP—A—0007015.

Such a cooling apparatus is used for cooling integrated circuit chips for computers and for power semiconductors such as thyristors.

A conventionally known boiling type cooling apparatus for IC chips, as represented by the EP—A—0007015, has chip-mounting printed circuit cards dipped longitudinally in a liquid. In the known cooling apparatus, the vapor bubbles produced from the chip rise and condense to be collected in a lower liquid reservoir. At the same time the chip is cooled by transmitting the heat of the chip to the cooling plate through a heat conducting member including a piston.

This type of cooling apparatus has some drawbacks. The bubbles produced by the semiconductor devices located at lower positions move up along the printed circuit card to surround the upper semiconductor chips. Not only does this raise the possibility or producing dry patches on the upper chips, making it impossible to obtain high heat transfer coefficient, but there is also the possibility of burnout.

The object of this invention is to provide a cooling apparatus of the boiling type which prevents the rising of bubbles and the liquid motion resulting from jolting during transport and which provides a uniform heat transfer coefficient for all integrated circuit chips mounted either on the upper or lower positions of the printed circuit card. According to the present invention this object is solved by the features described in the characterizing portion of claim 1.

From IBM — Technical Disclosure Bulletin, Vol 10, No 10, March 1968, New York, US, pages 1559—1560 it is known to arrange condensing fins at a cooled plate near semiconductor circuits. However said document does not disclose studs formed of heat conductive material attached to the surface of integrated circuit chips.

In contrast thereto, in case of the cooling apparatus of the present invention, the vapor bubbles produced by the chips or studs are trapped between the fins and condense into liquid which returns to around the chips.

The bubbles from the lower chips, generated during boiling, are trapped and condensed by fins which are provided for each chip, thereby preventing the bubbles from rising and reaching the upper chips.

For this purpose a condensing device with high heat transfer coefficient is provided for each chip. The condensing device may be formed by arranging a series of fins in form of a flat plate to increase the condensing area or by providing pointed, fine, screw-shaped fins about 0.1 to 2.0 mm in diameter. It is also desirable that the stud have a porous surface to aid the boiling process.

Embodiments of the invention are further explained with the aid of drawings, in which

Figure 1 is a simplified vertical cross section of the integrated circuit chip cooling apparatus, which is one embodiment of this invention;

Figure 2 is a front view of the printed circuit card of Figure 1 with the cooling plate removed;

Fig. 3 is a front view of the cooling plate of Figure 1;

Figure 4 is a diagram showing the characteristics of this invention;

Figure 5 is a simplified vertical cross section of another embodiment of this invention;

Figure 6 is a front view of the cooling plate of Figure 5; and

Figure 7 is a perspective view, partially cut away, of still another embodiment of this invention.

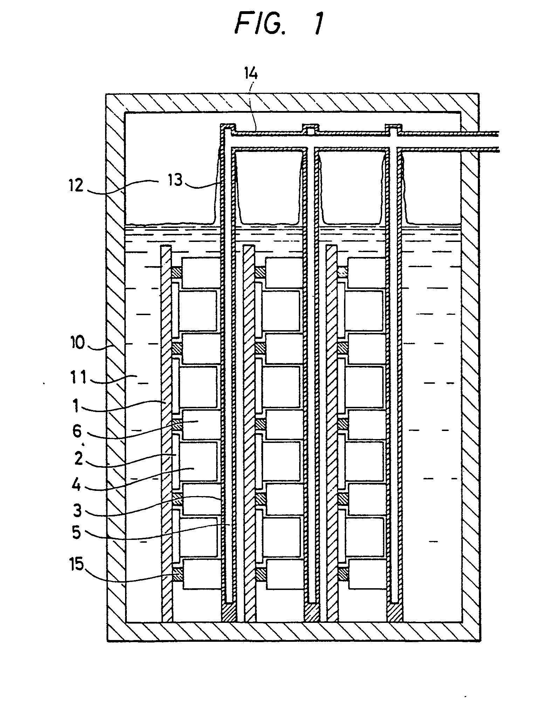

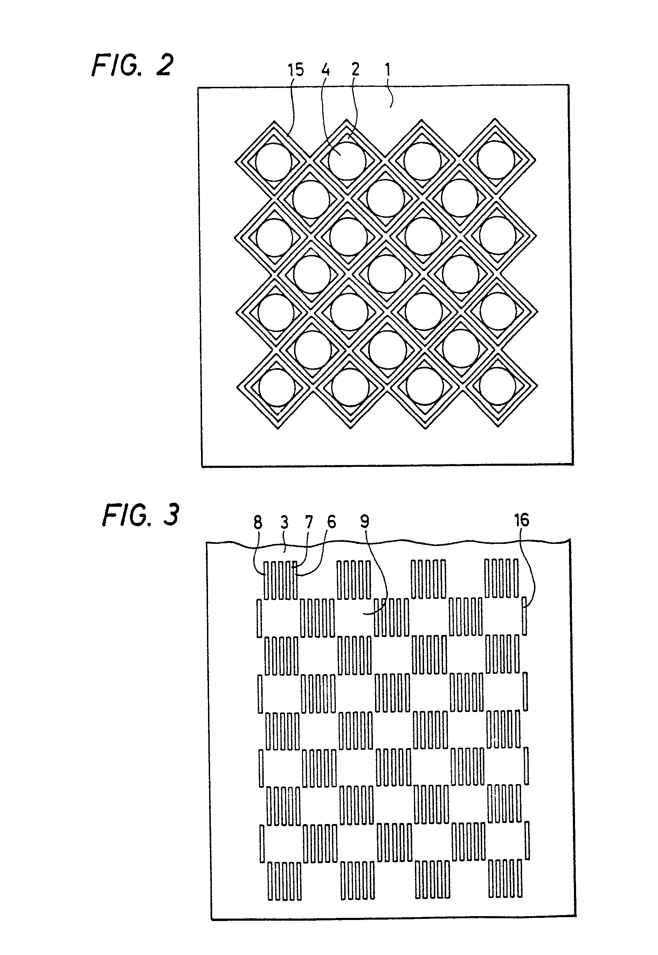

The first embodiment of this invention will be explained referring to Figures 1 through 3.

The printed circuit card 1 has many semiconductor chips 2 mounted thereon. A stud 4 made of a cylindrical, heat conducting member is secured to the top of each semiconductor chip 2. Between the adjacent printed circuit cards 1 are inserted a flat cooling plate 3 which has a cooling water passage 5 in it. A large number of thin fins 6, arranged parallel to each other with small gaps therebetween, are attached to the cooling plate 3. These fins 6 are arranged so that they enclose the stud 4. The fins 6 all align parallel to the direction of gravity. The area where the chip stud 4 is inserted is a space 9. A plurality of printed circuit cards 1 and cooling plates 3 are alternated with each other and submerged in a volatile liquid 11 (such a flon, perfluorocarbon compound, alcohol), in the enclosed container 10.

A part of the cooling plate 3 extends upward into a vapor space 12 to form an auxiliary condensing surface 13. Water piping 14 is provided to introduce water into the cooling water passage 5 in the cooling plate 3.

It is desirable that a resilient member 15 be inserted between the end of the fins 6 and the printed circuit card 1 and that the semiconductor chip 2 and stud 4 be completely enclosed by the fins 8.

The stud 4 has a porous surface.

Next, the action of this embodiment is described in the following.

The heat produced by the semiconductor chip 2 is transmitted to the stud 4 and, through the porous surface of the stud, boils the volatile liquid 11.

The vapor bubbles thus formed, being buoyant, rise upward and go into the narrow gaps 7 between the fins 6. If the gap size is smaller than the bubble, the vapor directly contacts the fins 6. The cooling water flowing in the passage 5 of the cooling plate 3 cools the cooling plate 3 and fins 6. Consequently the vapor condenses into liquid at the fin surface. The condensed liquid is drawn down by the force gravity and returns to the region around the stud 4. If there is a resilient member 15 provided between the end of the fins 6 and the printed circuit card 1, and if each semiconductor chip 2 and stud 4 are enclosed completely by fins 6, then the vapor bubbles produced at the stud 4 all enter the narrow gaps 7 between the fins 6, which enhance the condensing heat transfer coefficient. Where all the fins 6 are equal in length in the direction of gravity, the vapor bubbles enter and are distributed almost uniformly, among all the gaps between the fins 6, improving the condensing heat transfer coefficient.

A part of the vapor that has passed through the fin gaps 7 collects in the vapor space 12 in the upper part of the enclosed container 10 where it is condensed by the auxiliary condensing surface 13.

With this embodiment, since vapor condensation is performed for each semiconductor chip, all semiconductor chips can be cooled uniformly.

Next, the representative dimensions of this embodiment are given below. The semiconductor chip is square with each side measuring 2 to 20 mm; the stud diameter is about the same as the side of the chip. The fins attached to the cooling plate are about 0.1 to 1.0 mm thick; the gap between fins is about 0.1 to 1.0 mm. The material of the fins is preferably chosen from those which have high thermal conductivity such as copper, aluminum, and silicon carbide.

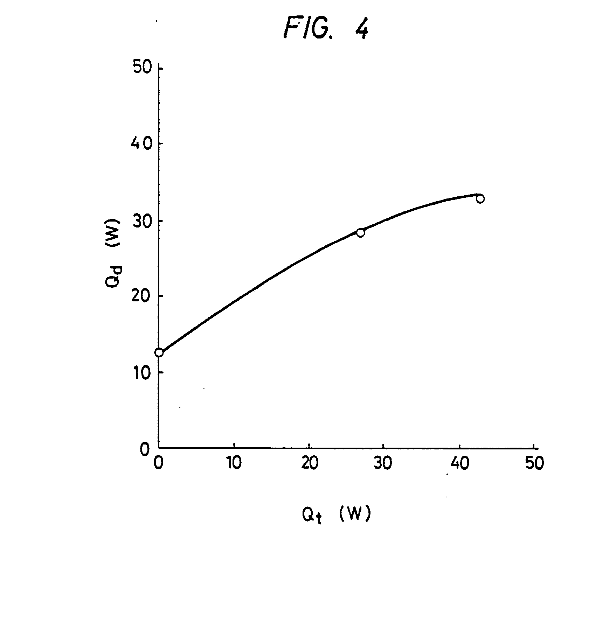

Figure 4 shows the result of experiment regarding the condensing heat conducting performance of this embodiment. In the experiment, the fin thickness is 0.3 mm; fin gaps are 0.2 mm each; fin length is 11 mm; fin height is 5.4 mm; the number of fins used is 25; and the liquid is perfluoro normal hexane. The temperture difference betwen the liquid and the cooling plate in this experiment is about 12°C. Let us look at the relation between the heat generated by a single semiconductor chip Qt and the heat removed by the fins Qd. It is seen that the plate removes about 30 W for each chip. The reason that the heat removed by the plate Qd is greater than Qt when the chip-generated heat Qt is below 30 W is that the liquid is supercooled while condensation is taking place. Further increase in the tempeature difference between the liquid and the cooling plate will increase the heat removed by the fins.

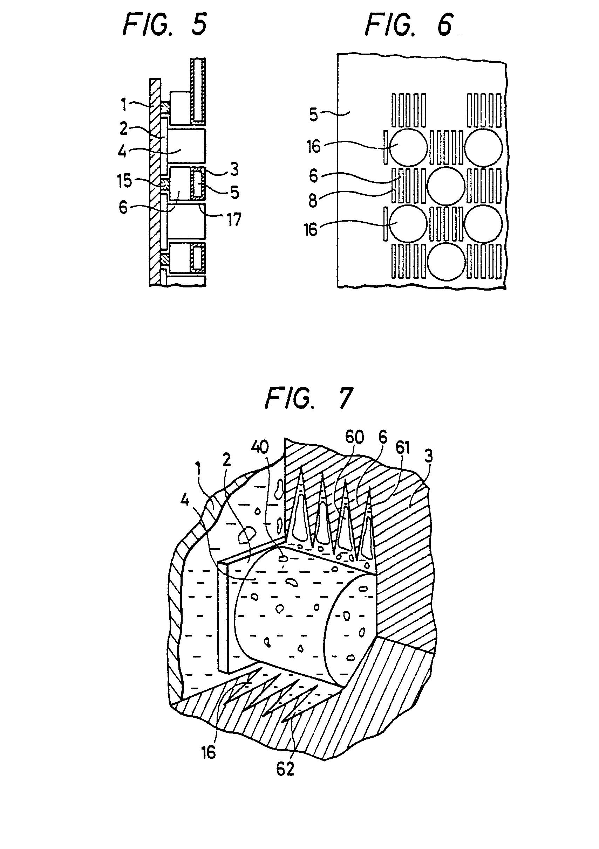

Figures 5 and 6 show another embodiment of this invention. In this embodiment, the fins 6 are made small in height and where there is no fin a hole is formed in the cooling plate to insert the stud. The cooling plate 3 and the stud 4 are equal in height to make the cooling structure small. Instead of fins 6, a large number of fine wires may be attached to the cooling plate 3.

In another embodiment shown in Figure 7, the fins 6 attached to the cooling plate 3 are formed into rings (or a female screw). The heat of the chip is conveyed to the stud 4 which boils the nearby liquid producing bubbles 40. Most of the bubbles are arrested between the ring-like fins 6 and trapped in the upper part 60 of the grooves of the fins. The vapor trapped in the upper part 60 of the fin grooves condenses on the groove wall and is drawn into the narrow recess 61 of the groove by capillary attraction. The condensed liquid now moves down the peripheral surface 62 of the narrow recess 61. In this way, almost all the vapor produced from each chip condenses near the chip. A small amount of vapor that has not been arrested by the cooling plate fins which enclose the stud 4 moves up and reaches the upper part of the container where it condenses into a thin layer of liquid which moves down returning to the liquid bath.

The recess of the cooling plate in which the stud is inserted has a large heat conducting area provided by the fins. Since the fins are used, provision of such a large heat conducting area does not result in any increase in the size of the cooling apparatus.

Although in this embodiment explanation is given to only the case where the stud is secured to the back of the chip, it is also possible to make the stud axially movable and while in the state of being pressed by the spring.

**Claims**

1. A cooling apparatus that cools, by the boiling action of a dielectric liquid (11), integrated circuit chips (2) mounted on printed circuit cards (1), submerged longitudinally in the dielectric liquid (11) with space between them, the cooling apparatus comprising: studs (4) formed of heat conductive material attached to the surface of the integrated circuit chips (2), cooling plates (3) arranged between the printed circuit cards (1), the plates (3) being cooled by circulating cooling medium, characterized by fins (6) attached to the cooling plate (3) and formed of heat conductive material, arranged so as to surround each stud (4).

2. The cooling apparatus, as defined in claim 1, in which the fins (6) are like a flat plate.

3. The cooling apparatus, as defined in claim 1, in which the fins (6) are like a female screw.

4. The cooling apparatus, as defined in claim 1, in which the studs (4) have a porous surface.

**Patentansprüche**

1. Kühlvorrichtung, welche durch die Siedewirkung einer dielektrischen Flüssigkeit (11) integrierte Schaltungschips (2) kühlt, welche auf gedruckten Schaltungen (1) angebracht sind, die in Längsrichtung in die dielectrische Flüssigkeit (11) mit einem Abstand zwischen sich untergetaucht sind, wobei die Kühlvorrichtung aus wärmeleitendem Material hergestellte Zapfen (4), die an der Oberfläche der integrierten Schaltungschips (2) befestigt sind, und zwischen den gedruckten Schaltungen (1) angeordnete Kühlplatten (3) aufweist, die durch Umwälzen eines Kühlmediums gekühlt werden, gekennzeichnet durch an der Kühlplatte (3) angebrachte und aus wärmeleitendem Material hergestellte Rippen (6), die so angeordnet sind, daß sie jeden Zapfen (4) umgeben.

2. Kühlvorrichtung nach Anspruch 1, bei welcher die Rippen (4) wie eine flache Platte ausgeführt sind.

3. Kühlvorrichtung nach Anspruch 1, bei welcher die Rippen (6) wie ein Muttergewinde ausgebildet sind.

4. Kühlvorrichtung nach Anspruch 1, bei welcher die Zapfen (4) eine poröse Oberfläche haben.

**Revendications**

1. Appareil de refroidissement qui refroidit, sous l'effet de l'action d'ébullition d'un liquide diélectrique (11), des puces à circuit intégré (2) montées sur des cartes à circuit imprimé (1), immergées dans le sens longitudinal dans le liquide diélectrique (11) avec un espace libre entre elles, cet appareil de refroidissement comprenant des plots (4) réalisés en matière thermo-conductrice et fixés sur la surface des puces à circuit intégré (2), des plaques de refroidissement (3) disposées entre les cartes à circuit imprimé (1), ces plaques (3) étant refroidies en faisant circuler un agent de refroidissement, caractérisé par des ailettes (6) solidaires de la plaque de refroidissement (3) et formées d'une matière thermo-conductrice, disposées de façon à entourer chaque plot (4).

2. Appareil de refroidissement suivant la revendication 1, dans lequel les ailettes (6) ont la forme d'une plaque plane.

3. Appareil de refroidissement suivant la revendication 1, dans lequel les ailettes (6) ont la forme d'une pièce à filetage femelle.

4. Appareil de refroidessement suivant la revendication 1, dans lequel les plots (4) offrent une surface poreuse.

FIG. 1

## FIG. 2

## FIG. 3

FIG. 4

# FIG. 5

# FIG. 6

# FIG. 7